# EUROPEAN PATENT SPECIFICATION

(11) **EP 3 777 032 B1**
(45) Date of publication and mention of the grant of the patent: **14.10.2026**
(21) Application number: 19716263.9
(22) Date of filing: 21.03.2019
(51) Int. Cl.: H04L 12/10, G01R 31/40, G01R 31/52, G01R 31/58

(54) **HIGH POWER DELIVERY FOR A POWER OVER ETHERNET (POE) COMMUNICATION SYSTEM**
HOHE LEISTUNGSÜBERTRAGUNG FÜR EIN POWER-OVER-ETHERNET-KOMMUNIKATIONSSYSTEM (POE)
DISTRIBUTION DE PUISSANCE ÉLEVÉE POUR UN SYSTÈME DE COMMUNICATION D'ALIMENTATION PAR ETHERNET (POE) DE MANIÈRE SÉCURISÉE

(30) Priority: 05.04.2018 US 201862653385 P; 27.06.2018 US 201816020881
(43) Date of publication of application: 17.02.2021
(73) Proprietor: Cisco Technology, Inc., San Jose, CA 95134 (US)
(72) Inventor: GOERGEN, Joel, Richard, Soulsbyville, CA 95372 (US); JONES, Chad, M., Doylestown, OH 44230 (US); SIRONI, Paolo, 21013 Gallarate (IT)
(74) Representative: Warren, Caroline Elisabeth
(86) International application number: PCT/US2019/023468
(87) International publication number: WO 2019/194985

(56) References cited:
- US-A1- 2008 310 067
- US-A1- 2012 317 426
- US-A1- 2017 155 518

## Description

### TECHNICAL FIELD

The present disclosure relates generally to communications networks, and more particularly, to safety features for power over communications systems.

### BACKGROUND

Power over Ethernet (PoE) is a technology for providing electrical power over a wired telecommunications network from power sourcing equipment (PSE) to a powered device (PD) over a link section. In conventional PoE systems that use 100W or less power sources, significant protection mechanisms are not needed because the limited power system classification does not cause destructive damage or life safety concerns. In newer systems that may exceed the 100W threshold, it is important to define safety protocol mechanisms that protect both the system and the **user.**
US 2012/0317426 describes a system for adjusting power provided to a device. The system can include power sourcing equipment and a sub-system. The power sourcing equipment can provide power to a powered deviee via a channel. The sub-system can determine an amount by which to increase the power based on a resistance of the channel. The power sourcing equipment or the powered device can adjust the power (or load) responsive to a command from the sub-system.
US 2008/0310067 A1 discloses a Power over Ethernet (PoE) system used in high power applications, that comprises a pulse width modulation (PWM) controller that controls power allocation of a power source equipment (PSE) port, based on electrical measurements of an Ethernet cable.
US 2017/155518 A1 discloses a Power over Ethernet-based power supply method for communications technology that comprises sending first Ethernet packet by a PSE to a PD when the line voltage drop across a network cable is greater than a line voltage drop threshold.

### BRIEF DESCRIPTION OF THE DRAWINGS

Aspects of the invention are as set out in the independent claims and optional features are set out in the dependent claims.
Figure 1 illustrates an example of a system in which examples described herein may be implemented.
Figure 2 is a front view of a dual route processor card chassis.
Figure 3 is a top view of the chassis shown in Figure 2.
Figure 4 illustrates a dual route processor chassis with an extended power shelf.
Figure 5A is a front view of a line card chassis.
Figure 5B is a front view of a dual line card chassis.
Figure 5C is a front view of a dual fabric chassis.
Figure 6 is a flowchart illustrating a process for wire fault and electrical imbalance detection, in accordance with one example.
Figure 7 is a block diagram of an electrical imbalance detection circuit for a power source, in accordance with one example.
Figure 8 is a block diagram of an electrical imbalance detection circuit for a powered device, in accordance with one example.
Figure 9 illustrates a wire verification process, in accordance with one example.
Figure 10 depicts an example of a network device useful in implementing examples described herein.

Corresponding reference characters indicate corresponding parts throughout the several views of the drawings.

### DESCRIPTION OF EXAMPLE EMBODIMENTS

### Overview

The present invention is defined in the appended independent claims to which reference should be made. Advantageous features are set out in the appended dependent claims.

### Example Embodiments

The maximum power delivery capacity of standard Power over Ethernet (PoE) is approximately 100 watts (W), but many classes of powered devices would benefit from power delivery of greater than 100W. For PoE applications exceeding 100W, there is a need for safety mechanisms to protect users and property.

**The** embodiments described herein provide safety systems and methods that allow for delivery of higher wattage power over communications cabling to safely deliver power exceeding 100W for higher ampacity applications beyond conventional 90W PoE implementations. The safety system may, for example, prevent unwanted electrical events such as shorts, opens, electrical imbalance, exceeding ampacity limits, or life safety concerns. In one example, the system may allow for a safe implementation of up to 300 watts of power delivered over a four-pair communications cable. The system may, for example, deliver 100W-300W power at a cable distance up to 15 meters. As deicribed in detail below, the examples may be implemented in a transport router with a RP (Route Processor) control plane in a separate system from line card optics. Both power and data are passed from the RP device to the line card device in a PSE (Power Sourcing Equipment) to PD (Powered Device) application.

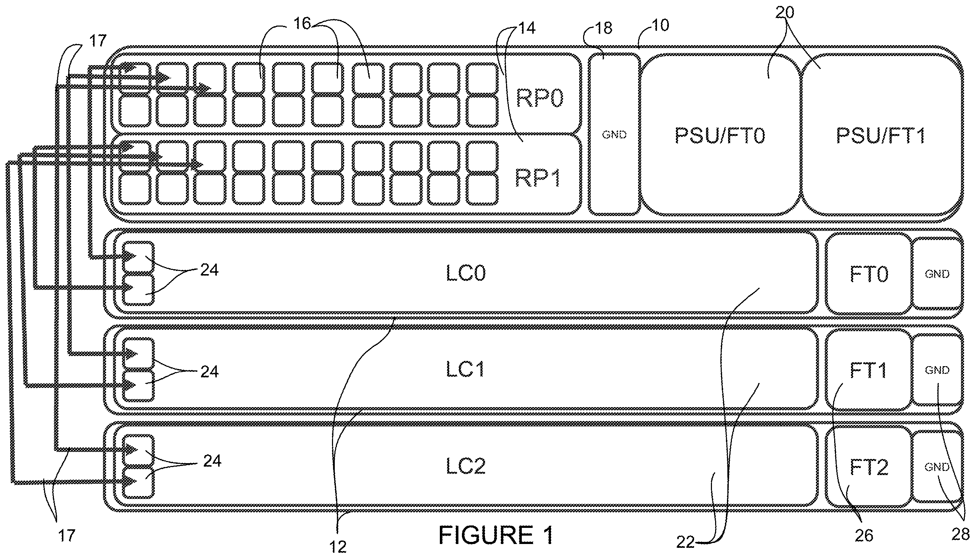

Referring now to the drawings, and first to Figure 1, an example of a modular transport system that may utilize power over communications cabling (also referred to herein as enhanced PoE) for power distribution. The modular transport system shown in Figure 1 includes a dual route processor (RP) card chassis 10 supplying control and power to three line card chassis 12. The dual RP card chassis may be, for example, a 2 RU (rack unit) chassis. The route processor card chassis 10 comprises two route processors 14 (RP0, RP1), each comprising twenty downlink ports 16, a dual port ground system 18, and two combination power supply unit (PSU) and fan tray modules 20 (PSU/FT0, PSU/FT1). The scalable transport system may support, for example, up to twenty redundant line card connections or eighteen line card connections and two fabric connections. Each downlink port 16 may support, for example, integrated 1Gb/s or 10Gb/s with a 300W power system. The downlink ports 16 supply control and power to each line card chassis 12 (or fabric chassis). In one example, the power supply units 20 provide dual 2kW AC or DC (or other power level) redundant power modules (1+1). Each line card chassis 12 comprises a line card 22 (LC0, LC1, LC2) comprising dual uplink ports 24, fan tray 26 (FT0, FT1, FT2), and a ground system 28. Power and data are transmitted from ports 16 at the route processors 14 to the ports 24 at the line cards 22 via cables 17. In this example, the route processor 14 is the PSE (Power Sourcing Equipment) and the line cards 22 are the PDs (Powered Devices) in the PoE distribution system.

In one example , the ports 16, 24 comprise interconnect ports that combine data and PoE utilizing an RJ45 (or similar connector). For example, the cable and connector system may comprise RJ45 cat7 style, 4 pair communications cabling. The ports 16, 24 may be labeled to identify capability for power over 90W. In one example, the cable and connector system may support ampacity per pin or wire to 2000ma, minimum. For example, 22 AWG (American Wire Gauge) wire may be used to support 1500ma-2000ma per wire in a cat7/cat5e cable system. In one example, the system may support a cable length of up to 15 meters (based on technology of cat7 cable, 22 AWG at 300W). In one or more examples , the internal PSE power supply voltage may operate in the 56V to 57V range, 57V to 58V range, or 56V to 58V range. For example, the output voltage at the PSE may be 57V with an input voltage at the PD of 56V. For a 15 meter cable, a 56V power supply at the PSE can deliver approximately 300W power. With less current, the system may also deliver power less than 300W to lengths beyond 15 meters, for example.

It is to be understood that the arrangement shown in Figure 1 is only an example, and other arrangements (e.g., number of route processors, PSUs, line cards, or uplinks/downlinks) may be used without departing from the scope of the examples. Furthermore, the connectors, cables, cable lengths, and power ranges described herein are only examples and that other types of connectors, length of cables, type of cable systems, or power levels may be used without departing from the scope of the examples.

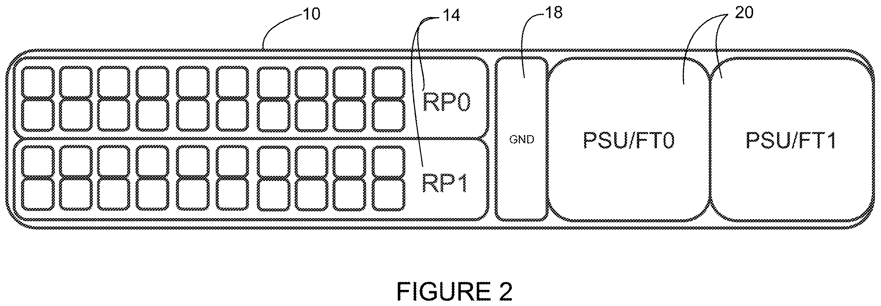

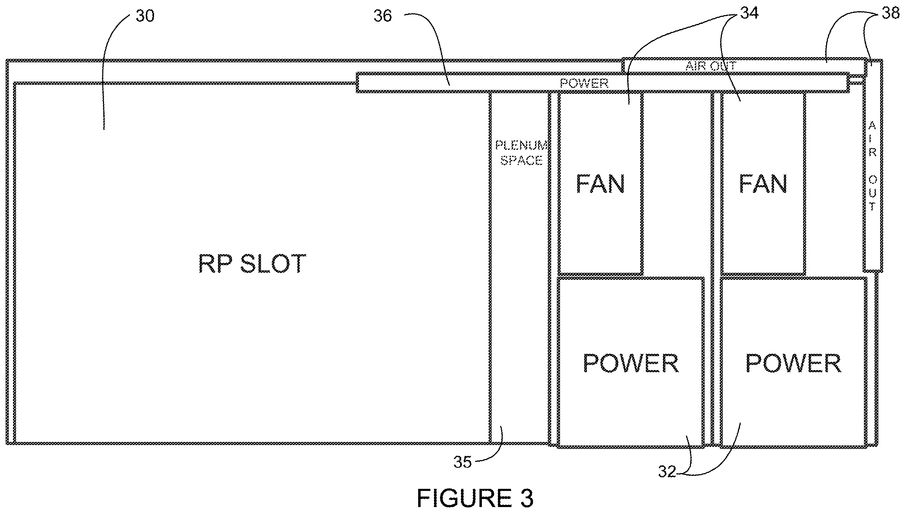

Figure 2 shows the dual RP card chassis 10 without the line card connections shown in Figure 1, and Figure 3 is a top view of the dual route processor card chassis shown in Figure 2. The route processors 14 are contained within a route processor (RP) slot 30 (Figure 3). Power supply units 32 are positioned in front of fans 34. A plenum space 35 is interposed between the combined power and fan modules and the RP slot 30. Routing of power is shown at 36 and air passages are depicted at 38.

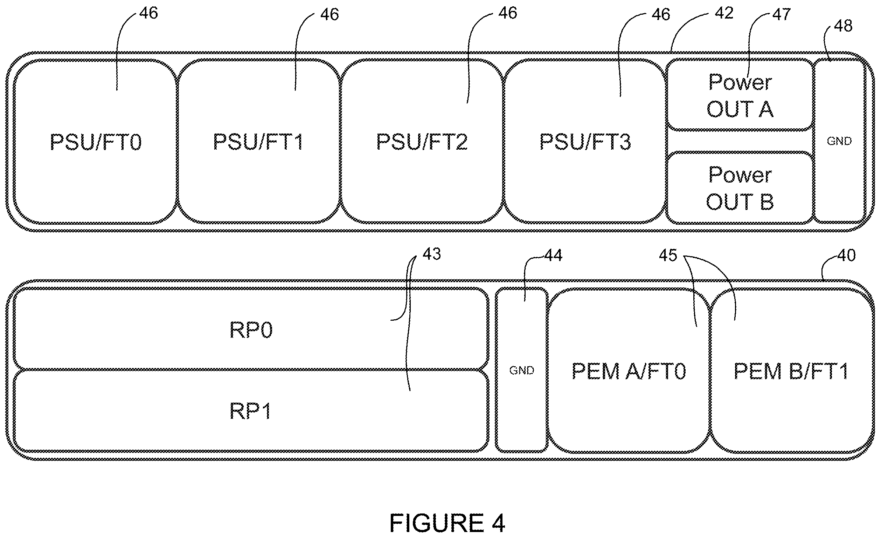

Figure 4 illustrates a front view of a dual route processor chassis 40 and an extended power system (shelf) 42. The extended power system 42 may be used, for example, to supply four 2kW redundant power modules (2+2) (e.g., double the delivered power capacity of the RP chassis 10 shown in Figure 1). The RP chassis 40 includes route processors 43 (RP0, RP1), ground system 44, and combined PEM (Power Entry Module) and fan tray 45 (PEM A/FT0, PEM B/FT1. In this example, the extended power shelf 42 includes four combined power supply units and fan trays 46 (PSU/FT0, PSU/FT1, PSU/FT2, PSU/FT3) and ground system 48. Power is supplied to the route processors 43 via two power outputs 47 (power OUT A, power OUT B). The route processor card chassis 40 receives power at the PEMs 45 and delivers power at downlink ports (not shown) as previously described with respect to Figure 1.

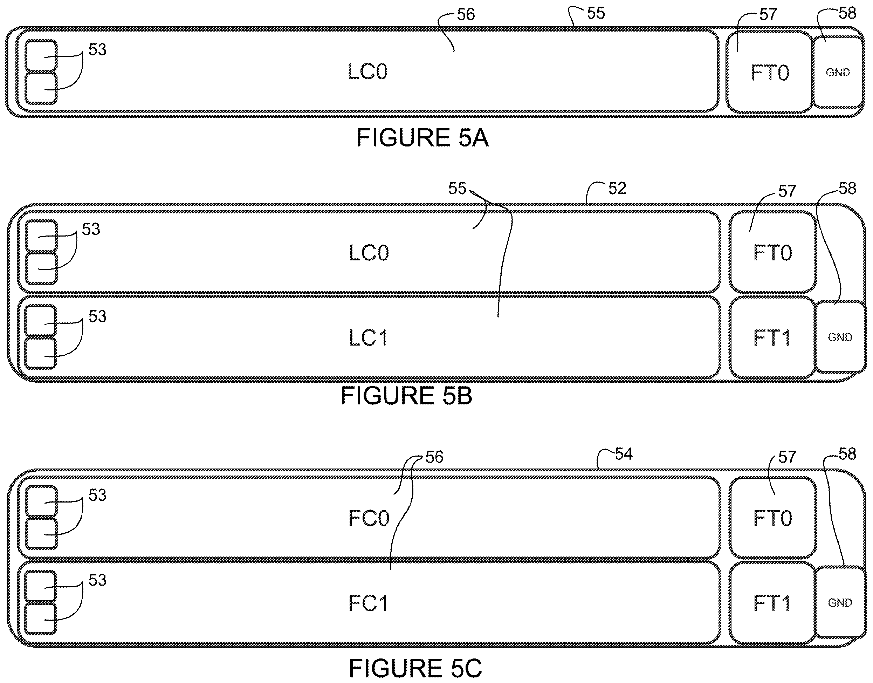

Figures 5A, 5B, and 5C illustrate a line card chassis 50, dual line card chassis 52, and dual fabric card chassis 54, respectively. Each line card (LC0, LC1) 55 and fabric card (FC0, FC1) 56 may support, for example, dual uplink ports 53 with 300W power. Each line card 55 and fabric card 56 has a corresponding fan tray (FT0, FT1) 57 and each chassis 50, 52, 54 includes a ground 58. The dual fabric chassis 54 may support multiple line card chassis.

It is to be understood that the components and arrangements shown in Figures 1, 2, 3, 4, 5A, 5B, and 5C are only examples of modular transport systems that may utilize the safety systems described herein for power over communications cable systems.

As previously described, higher power PoE distribution systems (e.g., ≥ 100W PoE) present a need for additional fault detection to safely protect equipment and users. The following describes a fault detection system and method that may be implemented on the modular transport systems described above with respect to Figures 1-5C or other transport systems configured for power over communications cabling (e.g., PoE above 100W, between 100W and 300W, approximately 300W). The fault detection (safety) system and method described herein may be used, for example, to prevent thermal buildup on a multi-pair cable system, wire-to-wire imbalance across a pair of wires, pair-to-pair imbalance, short circuit, or any combination thereof. As described below, thermal buildup may be detected by monitoring the current in a wire and calculating a change in temperature for a wire, wire pair, cable (e.g., four-pair cable) based on known wire parameters. A wire-to-wire imbalance may be detected across a pair if one of the two wires in a pair carries substantially more current than the other. A pair-to-pair imbalance may be detected if one of the pairs carries substantially more current than the other pairs. Each wire may also be evaluated to identify a short circuit or fault. An error or a minor or major alarm may be generated if a fault is detected. Depending on the severity of the detected fault, the power may be reduced or the port may be shutdown. For example, if the thermal buildup is minor, power may be reduced to reduce current on the line. If a short or other fault is detected on the wire or an electrical imbalance is detected, the corresponding port may be shutdown.

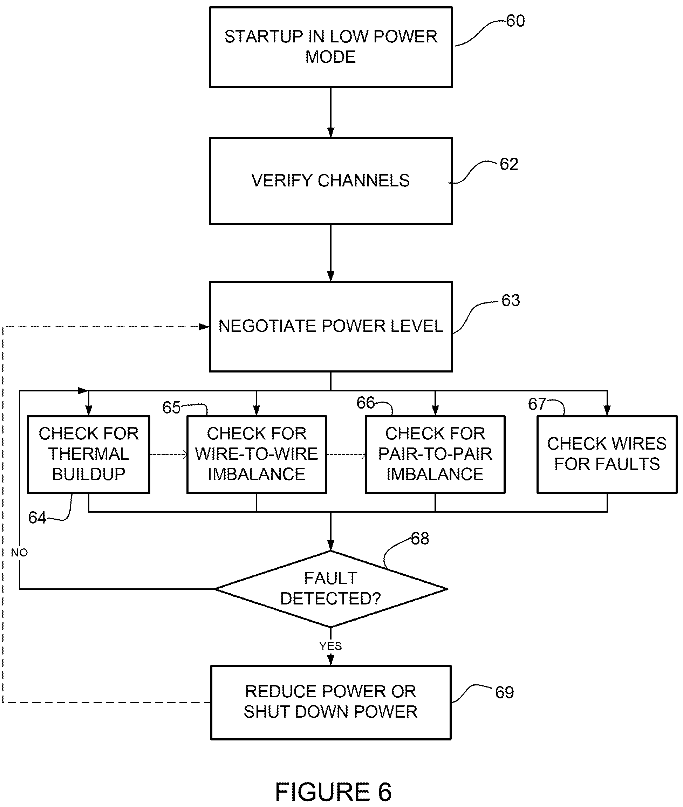

Figure 6 is a flowchart illustrating an overview of a process for detecting faults in the power over communications -cabling system, in accordance with one example. At step 60, the system starts up in a low power mode (e.g., ≤90W or other low power setting) using, for example, IEEE standard 802.3bt for Power over Ethernet (e.g., class 8). A channel verification algorithm may be performed to evaluate links before applying power (step 62). For example, a monitoring process may roll through the wires to verify wire connectivity. The system may then use CDP (Cisco Discovery Protocol) (or any other suitable protocol) to negotiate for power above 90W, in a similar manner that UPoE (Universal Power over Ethernet) negotiates up to 60W from a 15W or 30W start (step 63). In one example, the PSE may inform the PD of a power level that the PSE is capable of providing and the PD may then select the appropriate power level to use. The PSE and PD may negotiate power levels, for example, of 15W, 30W, 60W, 90W, 150W, 200W, 250W, 300W, or any other suitable power level. If no faults are detected, the system may auto negotiate to maximum available power. Ethernet management packets may be used to enable allocation to 300W maximum power, for example.

Once the power is increased, fault detection is performed, as described in detail below. Fault detection may include for example, a check for thermal buildup (step 64), electrical imbalance check (wire-to-wire imbalance check (step 65), pair-to-pair imbalance check (step 66)), or short circuit/fault protection check (step 67). The system may be configured to perform one or more of these checks in any order (as indicated in one example by dashed lines between steps in Figure 6) or some steps may be performed simultaneously. One or more of the safety checks may be performed continuously or at specified intervals. For example, the wires may be monitored one by one in a continuous loop within a 10ms window. If a fault is detected or a specified PSE voltage (e.g., 58.5V) is exceeded, power output is shutdown (steps 68 and 69). If the fault is minor (e.g., one or more parameters close to limit but not exceeding limit), power may be reduced through renegotiation of the power level. If the fault continues, the port may then be shutdown. An alarm may also be generated. In one or more examples , packet and idle (link) monitoring may be used to shut down the power. If a wire is lost, the link is lost and per wire faults are covered.

It is to be understood that the process shown in Figure 6 and described above is only an example and that steps may combined, added, removed, or modified, without departing from the scope of the examples.

The following describes details of safety checks (fault detection) that may be performed for steps 64-67 of Figure 6.

In one or more examples , thermal buildup is detected by tracking cable current change and calculating cable current temperature. The cable temperature is a function of amperage, cable gauge, and length of cable. By using known parameters and assuming a wire size (e.g., 22 AWG), the temperature limit of the cable in a bundle environment may be calculated. Temeprature ranges may be defined, for example, as normal, minor, major, and critical (e.g., minor defined within 20 C° of cable temperature limit, major defined within 10 C° of cable temperature limit, and critical defined at cable temperature limit). If the temperature range is in the minor range, the system may force renegotiation of power to reduce current on the line. If the temperature is in the critical range, the port may be de-energized. The temperature may be calculated in each wire, each pair of wires, the four-pair cable, or any combination. Thermal modeling of the cable may be performed as described in U.S. Patent

No. 10,809,134, entitled "Thermal Modeling for Cables Transmitting Data and Power", filed May 24, 2017, for use in fault detection, for example.

Action may also be taken based on the monitored (or calculated) current. For example, if the current in the cable exceeds the cable current maximum limit, the port may be shutdown. If the cable current reaches a specified range, the line card (PD) may be forced to perform power negotiation with the PSE to reduce current on the line. The current may be monitored per wire, per pair of wires, per cable, or any combination. Current ranges may be defined as normal, minor, major, and critical (e.g., minor defined within 20% maximum current, major defined within 10% maximum current, and critical defined at maximum current). If the range is minor, renegotiation may be performed to reduce current on the cable. If the critical current is reached, the port may be de-energized.

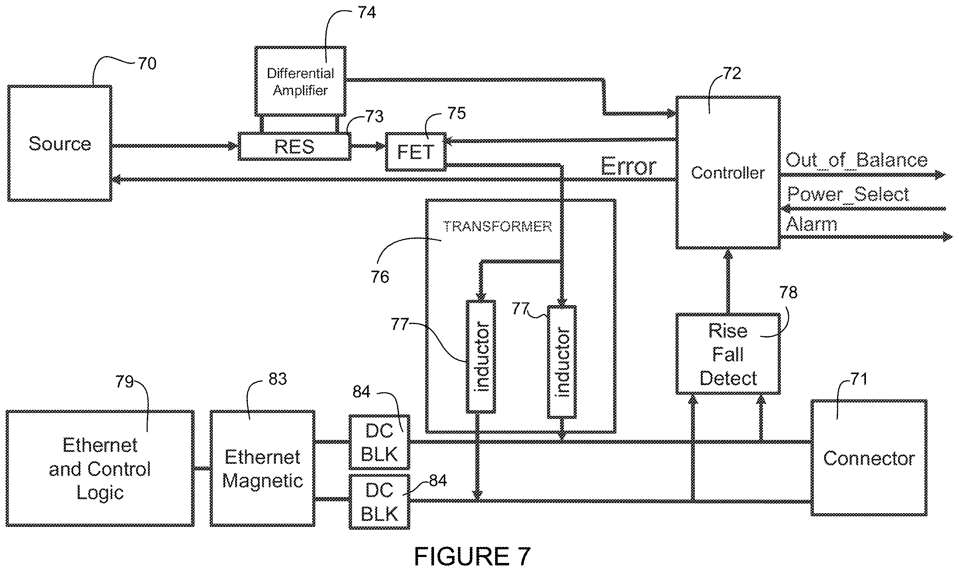

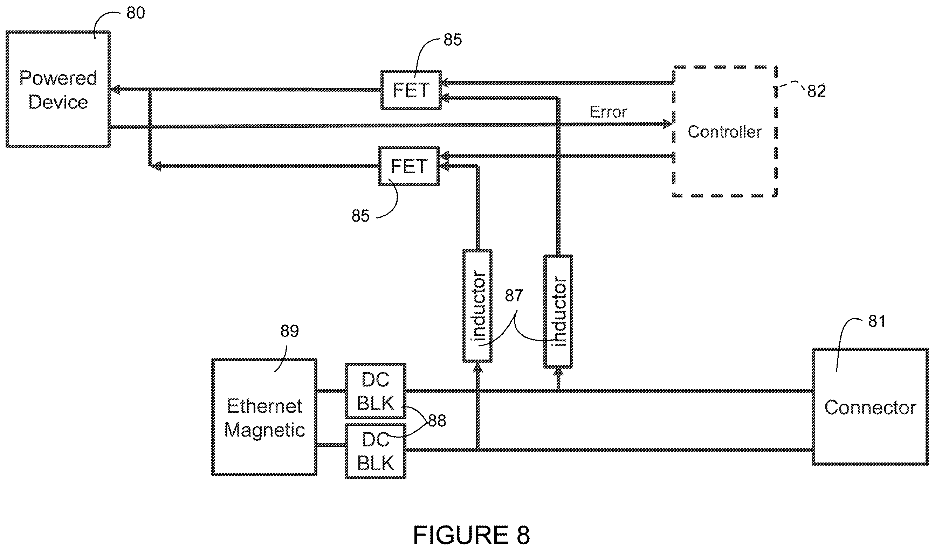

As shown in steps 65 and 66 of Figure 6, a fault is identified based on electrical imbalance. Wire-to-wire imbalance (between wires within a pair of wires) and pair-to-pair imbalance (between pairs of wires) may be tracked. An alarm may be generated if wire-to-wire or pair-to-pair imbalance exceeds a specified limit. Cable degradation may also be tracked and a minor alarm generated upon detection of a wire-to-wire or pair-to-pair imbalance. An example of a pair-to-pair imbalance detection circuit is. shown in Figure 7 for a PSE and Figure 8 for a PD and described below.

In one or more examples , a fault detection circuit provides per pair fault and imbalance detection in a four-pair communications cable (e.g., cable comprising at least two pairs of wires). The fault detection circuit individually monitors and looks for current disparity, examines live load to negotiated load, and considers automatic load leveling across wires for impedance changes. Per wire faults may be detected using a center tap and link monitor.

Figure 7 illustrates an example of a fault detection circuit for per pair fault and imbalance detection at a PoE source, in accordance with one example . The fault detection is performed for each port (e.g., port 16 at route processor 14 in Figure 1) at the PSE source. For simplification the circuit is shown for one of the four-pairs of wires at one of the ports. A circuit is provided for fault detection for each pair of wires. The circuit shown in Figure 7 is located at the PSE (route processor 14 in Figure 1) and provides a check from a power source 70 to a connector 71 at the port. The source 70 may provide, for example, 58VDC, or other suitable power level, as previously described. The connector 71 may comprise, for example, an RJ45 connector for providing power and data over a cable to the powered device (e.g., line card 22 in Figure 1).

A microcontroller 72 (e.g., PIC (Programmable Interface Controller)) may be used to compare all four pairs and provide an indication of an out of balance condition or fault and initiate an alarm. The power passes from the source 70 through resistor 73, which is in communication with a differential amplifier 74. The circuit includes a field effect transistor (FET) 75 receiving input from the source 70 (via the resistor 73) and the controller 72, and providing input to a transformer 76 comprising a pair of inductors 77. Power is transmitted to the connector 71 from the transformer 76. The controller 72 also receives input from a rise and fall detector 78 tapped into Ethernet lines. Ethernet data and control logic is provided by module 79. The Ethernet circuit includes Ethernet magnetics 83 and DC blocks 84.

In order to avoid the use of large magnetics to handle both data and power, the system may use passive coupling instead of integrated magnetics for data transfer. The system uses AC coupling instead of passing through the Ethernet magnetics 79. This avoids the use of large magnetics to handle both data and power. Capacitors may be used to block the DC power from the Ethernet magnetics to prevent a short. In one example, capacitors are used inline and inductors are used to deliver power with matched power inductors.

Figure 8 illustrates an example of a circuit for per pair fault and imbalance detection at a powered device 80 (e.g., line card 22 in Figure 1), in accordance with one embodiment. As described above with respect to Figure 7, the circuit is shown for only one of the four pairs for simplification. The powered device 80 receives power and data from the PSE through the connector 81 (e.g., RJ45 connector). Power is transmitted through inductors 87 and passes through field effect transistors (FETs) 85. A controller 82 (optional) compares the four pairs to check for an imbalance between pairs. The circuit in Figure 8 may also be configured without intelligence (e.g., with controller 82 removed). In this case, error control is provided directly to the FETs 85 from the PD 80 (instead of to the controller). The Ethernet portion of the circuit includes Ethernet magnets 89 and DC blocks 88, as previously described.

As previously noted, the system may also check the wires for short circuit and provide fault protection for life safety by analyzing each wire in the cable system within a time period of 10ms, which is known not to interfere with human health. In one embodiment, the system uses a control loop to evaluate wire stability at a periodic interval (e.g., 9ms, 10ms). In one example, a safety algorithm loops within a 10ms window. Each wire is monitored for line abnormalities such as shorts and opens at the PSE. Voltage is measured and if there is no error, the loop is repeated. All wires are powered and at time n a first wire (n) is de-energized. The system cuts power on wire 1 for 0.25ms or less and may evaluate power to zero time. The system may wait 100ms, for example (wait time contributes to keep average current higher without burst), and then loops to the next wire. Fall time is monitored and calculated based on wire gauge modeled to wire length maximum/ minimum range. The wire may also be driven negative to force a shorter monitor time. At time (n) +0.25ms, a next wire is energized. Rise time is monitored and calculated to wire gauge modeled to wire length maximum/ minimum range. This process continues until all wires are checked. In this example, the total process takes 10ms.

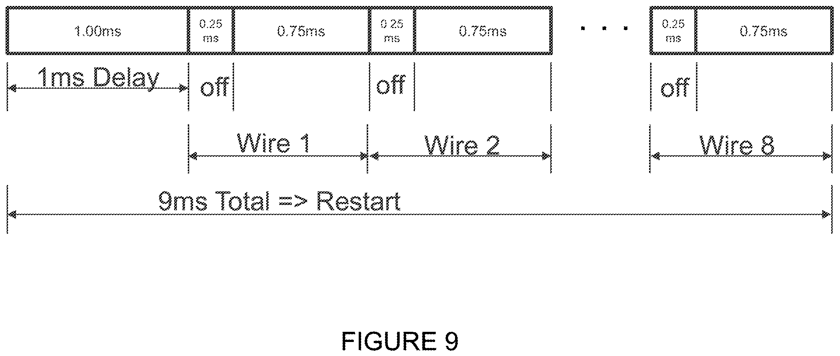

Figure 9 illustrates another example, in which each wire is tested after a lms delay. Wire 1 is turned off for 0.25ms followed by a 0.75ms delay to evaluate power drop. This process is repeated for all eight wires, resulting in a 9ms cycle.

The safety algorithm described above may introduce a repetitive frequency base that may result in both low frequency radiated emissions and high range conducted emissions. The following algorithms may be deployed to make the safety mechanism more randomly distributed and avoid this repetitive frequency base.

In order to eliminate EMC (electromagnetic compatibility) spectral peaking, the algorithm varies the wire_x time span shown in Figure 9 as 0.25ms+0.75ms=1.00ms. Two random numbers may be generated; one number selects the wire_x to target (integer 1 - 8) and the other number selects the delay time to the next wire_x (0.1ms - 0.75ms). This results in each off time location being distributed across the 9ms window, as defined within the standard 10ms safety evaluation time window.

It is to be understood that the above described process and time intervals used in the fault detection process are only examples and that the process may include different time intervals or algorithms, without departing from the scope of the examples.

The examples operate in the context of a data communications network including multiple network devices. The network may include any number of network devices in communication via any number of nodes (e.g., routers, switches, gateways, controllers, access points, or other network devices), which facilitate passage of data within the network. The network devices may communicate over or be in communication with one or more networks (e.g., local area network (LAN), metropolitan area network (MAN), wide area network (WAN), virtual private network (VPN) (e.g., Ethernet virtual private network (EVPN), layer 2 virtual private network (L2VPN)), virtual local area network (VLAN), wireless network, enterprise network, corporate network, data center, Internet of Things (IoT), Internet, intranet, or any other network).

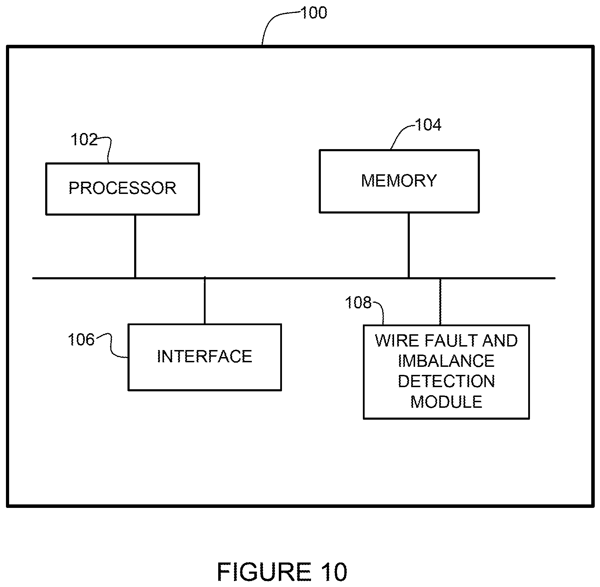

Figure 10 illustrates an example of a network device 100 (e.g., transport system, route processor card chassis in Figure 1) that may be used to implement the examples described herein. In one example the network device 100 is a programmable machine that may be implemented in hardware, software, or any combination thereof. The network device 100 includes one or more processors 102, memory 104, interface 106, and wire fault and pair imbalance detection module 108.

Memory 104 may be a volatile memory or non-volatile storage, which stores various applications, operating systems, modules, and data for execution and use by the processor 102. For example, components of the wire fault and imbalance detection module 108 (e.g., code, logic, or firmware, etc.) may be stored in the memory 104. The network device 100 may include any number of memory components.

The network device 100 may include any number of processors 102 (e.g., single or multi-processor computing device or system), which may communicate with a forwarding engine or packet forwarder operable to process a packet or packet header. The processor 102 may receive instructions from a software application or module, which causes the processor to perform functions of one or more examples described herein.

Logic may be encoded in one or more tangible media for execution by the processor 102. For example, the processor 102 may execute codes stored in a computer-readable medium such as memory 104. The computer-readable medium may be, for example, electronic (e.g., RAM (random access memory), ROM (read-only memory), EPROM (erasable programmable read-only memory), magnetic, optical (e.g., CD, DVD), electromagnetic, semiconductor technology, or any other suitable medium. In one example, the computer-readable medium comprises a non-transitory computer-readable medium. Logic may be used to perform one or more functions described above with respect to the flowchart of Figure 6 or other functions such as power level negotiations or safety subsystems described herein. The network device 100 may include any number of processors 102.

The interface 106 may comprise any number of interfaces or network interfaces (line cards, ports, connectors) for receiving data or power, or transmitting data or power to other devices. The network interface may be configured to transmit or receive data using a variety of different communications protocols and may include mechanical, electrical, and signaling circuitry for communicating data over physical links coupled to the network or wireless interfaces. For example, line cards may include port processors and port processor controllers. The interface 106 may be configured for PoE, enhanced PoE, PoE+, UPoE, or similar operation.

The wire fault and imbalance detection module 108 may comprise hardware or software for use in fault detection described herein.

It is to be understood that the network device 100 shown in Figure 10 and described above is only an example and that different configurations of network devices may be used. For example, the network device 100 may further include any suitable combination of hardware, software, algorithms, processors, devices, components, or elements operable to facilitate the capabilities described herein.

In summary, in one embodiment, a method includes transmitting Power over Ethernet (PoE) in a PoE distribution system at a power greater than 100 watts, the distribution system comprising at least two pairs of wires, monitoring a thermal condition in the distribution system, periodically checking each of the wires for a fault, and checking for an electrical imbalance at the wires. An apparatus is also disclosed herein.

## Claims

1. A method comprising:
transmitting power, by a route processor (14), in a Power over Ethernet, PoE, distribution system at a power less than 100 watts at startup;
negotiating a power level between Power Sourcing Equipment, PSE, and a Powered Device, PD, in the PoE distribution system, and increasing the power to greater than 100 watts, wherein the PoE distribution system comprises at least two pairs of wires, the PSE comprising the route processor (14) and the PD comprising a line card (22);
performing fault detection, by a fault detection module (108), by :
monitoring (64) a thermal condition in the distribution system, wherein monitoring (64) said thermal condition comprises tracking current change and calculating a change in temperature for a wire to identify thermal buildup;
periodically checking (67) each of the wires for a fault;
wherein periodically checking (67) each of the wires for the fault comprises evaluating wire stability at least once within a time period of 10 milliseconds;
further comprising cutting power to one of the wires for at least 0.25 milliseconds and evaluating the wire and repeating for each of the wires; and
checking (65, 66) for an electrical imbalance at the wires; and
in the event that a fault is detected in response to the thermal buildup and/or the electrical imbalance exceeding a specified limit, by the fault detection module (108), reducing power through renegotiation of the power level between the PSE and the PD, or the power output is shutdown at the PSE.

2. The method of claim 1 wherein checking (65, 66) for an electrical imbalance comprises checking for an electrical imbalance between said pairs of wires.

3. The method of claim 1 or 2 wherein checking (65, 66) for an electrical imbalance comprises checking for an electrical imbalance between the wires.

4. The method of any of claims 1 to 3 further comprising setting an alarm upon identifying said fault in one of said wires or said electrical imbalance.

5. The method of any of claims 1 to 4 further comprising identifying a cable temperature within a percentage of a temperature limit and reducing a power level.

6. The method of any of claims 1 to 5 wherein the Power Sourcing Equipment has an output voltage between 56 volts and 58 volts.

7. The method of claim 6, further comprising detecting that the output voltage at the PSE exceeds 58.5 volts and shutting down (69) the output voltage.

8. An apparatus comprising:
a route processor (14) operable as a power source in a Power over Ethernet, PoE, distribution system, the route processor (14) comprising:
a plurality of ports (16) for delivering power to a plurality of powered devices; and
a fault detection module (108) for performing fault detection by monitoring a thermal condition in the distribution system, periodically checking wires at each of the ports for a fault, wherein monitoring said thermal condition comprises tracking current change and calculating a change in temperature for a wire to identify thermal buildup, and
wherein periodically checking wires at each of the ports for the fault comprises evaluating wire stability at least once within a time period of 10 milliseconds,
further comprising cutting power to one of the wires for at least 0.25 milliseconds and evaluating the wire and repeating for each of the wires; and
checking for an electrical imbalance at the wires;
wherein the route processor (14) is operable to transmit power in the PoE distribution system at a power less than 100 watts at startup, negotiate a power level with the plurality of powered devices, and transmit power greater than 100 watts to the powered devices; and
in the event that a fault is detected in response to the thermal buildup and/or the electrical imbalance exceeding a specified limit, the fault detection module (108) is operable to reduce power through renegotiation of the power level or shutdown power output at the route processor (14).

9. A computer program, computer program product or computer readable medium comprising instructions which, when executed by a computer, cause the computer to carry out the steps of the method of any of claims 1 to 7.

## Patentansprüche

1. Verfahren, Folgendes umfassend:
Übertragen von Leistung durch einen Routenprozessor (14) in einem Power-over-Ethernet-, PoE-, Verteilungssystem bei einer Leistung von weniger als 100 Watt beim Anlaufen;
Aushandeln eines Leistungsniveaus zwischen einer Leistungsversorgungseinrichtung, Power Sourcing Equipment, PSE, und einem mit Leistung versorgten Gerät, Powered Device, PD, in dem PoE-Verteilungssystem und Erhöhen der Leistung auf über 100 Watt, wobei das PoE-Verteilungssystem mindestens zwei Aderpaare umfasst, die PSE den Routenprozessor (14) umfasst und das PD eine Leitungskarte (22) umfasst;
Durchführen von Fehlererkennung durch ein Fehlererkennungsmodul (108) durch:
Überwachen (64) einer thermischen Bedingung in dem Verteilungssystem, wobei das Überwachen (64) der thermischen Bedingung das Nachverfolgen einer Stromveränderung und das Berechnen einer Veränderung der Temperatur für eine Ader zum Identifizieren eines Wärmeaufbaus umfasst;
periodisches Prüfen (67) jeder der Adern auf einen Fehler;
wobei das periodische Prüfen (67) jeder der Adern auf den Fehler das mindestens einmalige Bewerten der Aderstabilität innerhalb einer Zeitspanne von 10 Millisekunden umfasst;
ferner das Abschneiden von Leistung für eine der Adern für mindestens 0,25 Millisekunden und das Bewerten der Ader und das Wiederholen für jede der Adern umfassend; und
Prüfen (65, 66) auf ein elektrisches Ungleichgewicht an den Adern; und
wenn in Reaktion auf den Wärmeaufbau und/oder darauf, dass das elektrische Ungleichgewicht eine spezifizierte Grenze überschreitet, durch das Fehlererkennungsmodul (108) ein Fehler erkannt wird, Reduzieren der Leistung durch Neuverhandeln des Leistungsniveaus zwischen dem PSE und dem PD oder der Leistungsausgang am PSE wird abgeschaltet.

2. Verfahren nach Anspruch 1, wobei das Prüfen (65, 66) auf ein elektrisches Ungleichgewicht das Prüfen eines elektrischen Ungleichgewichts zwischen den Aderpaaren umfasst.

3. Verfahren nach Anspruch 1 oder 2, wobei das Prüfen (65, 66) auf ein elektrisches Ungleichgewicht das Prüfen eines elektrischen Ungleichgewichts zwischen den Adern umfasst.

4. Verfahren nach einem der Ansprüche 1 bis 3, ferner das Setzen eines Alarms auf das Identifizieren des Fehlers in einer der Adern oder des elektrischen Ungleichgewichts hin.

5. Verfahren nach einem der Ansprüche 1 bis 4, ferner das Identifizieren einer Kabeltemperatur innerhalb eines Prozentsatzes einer Temperaturgrenze und das Reduzieren eines Leistungsniveaus umfassend.

6. Verfahren nach einem der Ansprüche 1 bis 5, wobei die Leistungsversorgungseinrichtung eine Ausgangsspannung zwischen 56 Volt und 58 Volt aufweist.

7. Verfahren nach Anspruch 6, ferner das Erkennen, dass die Ausgangsspannung an der PSE 58,5 Volt übersteigt, und Abschalten (69) der Ausgangsspannung umfassend.

8. Vorrichtung, Folgendes umfassend:
einen Routenprozessor (14), der als eine Leistungsversorgung in einem Power-over-Ethernet-, PoE-, Verteilungssystem funktionsfähig ist, wobei der Routenprozessor (14) Folgendes umfasst:
eine Vielzahl von Anschlüssen (16) zum Liefern von Leistung an eine Vielzahl von mit Leistung versorgten Geräten; und
ein Fehlererkennungsmodul (108) zum Durchführen einer Fehlererkennung durch Überwachen einer thermischen Bedingung in dem Verteilungssystem, periodisches Prüfen von Adern an jedem der Anschlüsse auf Fehler, wobei das das Überwachen der thermischen Bedingung das Nachverfolgen einer Stromveränderung und das Berechnen einer Veränderung der Temperatur für eine Ader zum Identifizieren eines Wärmeaufbaus umfasst, und
wobei das periodische Prüfen von Adern an jedem der Anschlüsse auf den Fehler das mindestens einmalige Bewerten der Aderstabilität innerhalb einer Zeitspanne von 10 Millisekunden umfasst,
ferner das Abschneiden von Leistung für eine der Adern für mindestens 0,25 Millisekunden und das Bewerten der Ader und das Wiederholen für jede der Adern umfassend; und
Prüfen auf ein elektrisches Ungleichgewicht an den Adern;
wobei der Routenprozessor (14) funktionsfähig ist, Leistung in dem PoE-Verteilungssystem mit einer Leistung von weniger als 100 Watt beim Anlaufen zu übertragen, ein Leistungsniveau mit der vielzahl von mit Leistung versorgten Geräten auszuhandeln und Leistung von mehr als 100 Watt an die mit Leistung versorgten Geräte zu übertragen; und
wenn in Reaktion auf den Wärmeaufbau und/oder darauf, dass das elektrische Ungleichgewicht eine spezifizierte Grenze überschreitet, ein Fehler erkannt wird, das Fehlererkennungsmodul (108) funktionsfähig ist, Reduzieren die Leistung durch Neuverhandeln des Leistungsniveaus oder Abschalten des Leistungsausgangs am Routenprozessor (14) zu reduzieren.

9. Computerprogramm, Computerprogrammprodukt oder computerlesbares Medium, das Anweisungen umfasst, die bei Ausführung durch einen Computer bewirken, dass der Computer die Schritte des Verfahrens nach einem der Ansprüche 1 bis 7 durchführt.

## Revendications

1. Procédé comprenant :
la transmission d'énergie, par un processeur de routage (14), dans un système de distribution d'alimentation via Ethernet, PoE, à une puissance inférieure à 100 watts au démarrage ;
la négociation d'un niveau de puissance entre un équipement d'alimentation électrique, PSE, et un dispositif alimenté, PD, dans le système de distribution PoE, et l'augmentation de la puissance à plus de 100 watts, dans lequel le système de distribution PoE comprend au moins deux paires de fils, le PSE comprenant le processeur de routage (14) et le PD comprenant une carte de ligne (22) ;
l'effection d'une détection de défaut, par un module de détection de défaut (108), par :
la surveillance (64) d'une condition thermique dans le système de distribution, dans lequel la surveillance (64) de ladite condition thermique comprend le suivi du changement de courant et le calcul d'un changement de température pour identifier une accumulation thermique ;
la vérification périodique (67) de chacun des fils pour déceler un défaut ;
dans lequel la vérification périodique (67) de chacun des fils pour déceler le défaut comprend l'évaluation de la stabilité des fils au moins une fois dans un intervalle de temps de 10 millisecondes ;
comprenant en outre la coupure de l'alimentation sur un des fils pendant au moins 0,25 milliseconde et l'évaluation du fil et la répétition pour chacun des fils ; et
la vérification (65, 66) d'un déséquilibre électrique au niveau des fils ; et
dans le cas où un défaut est détecté en réponse à l'accumulation thermique et/ou au déséquilibre électrique dépassant une limite spécifiée, par le module de détection de défaut (108), la réduction de la puissance par la renégociation du niveau de puissance entre le PSE et le PD, ou la sortie de puissance est coupée au niveau du PSE.

2. Procédé selon la revendication 1, dans lequel la vérification (65, 66) d'un déséquilibre électrique comprend la vérification d'un déséquilibre électrique entre lesdites paires de fils.

3. Procédé selon la revendication 1 ou 2, dans lequel la vérification (65, 66) d'un déséquilibre électrique comprend la vérification d'un déséquilibre électrique entre les fils.

4. Procédé selon l'une quelconque des revendications 1 à 3, comprenant en outre la fourniture d'une alarme lors de l'identification dudit défaut dans l'un desdits fils ou dudit déséquilibre électrique.

5. Procédé selon l'une quelconque des revendications 1 à 4, comprenant en outre l'identification d'une température de câble dans un pourcentage d'une limite de température et la réduction d'un niveau de puissance.

6. Procédé selon l'une quelconque des revendications 1 à 5, dans lequel l'équipement d'alimentation électrique a une tension de sortie comprise entre 56 volts et 58 volts.

7. Procédé selon la revendication 6, comprenant en outre la détection du fait que la tension de sortie au niveau du PSE dépasse 58,5 volts et la coupure (69) de la tension de sortie.

8. Appareil comprenant :
un processeur de routage (14) utilisable comme source d'alimentation dans un système de distribution d'alimentation via Ethernet, PoE, le processeur de routage (14) comprenant :
une pluralité de ports (16) pour fournir de l'énergie à une pluralité de dispositifs alimentés ; et
un module de détection de défaut (108) pour effectuer une détection de défaut en surveillant une condition thermique dans le système de distribution, en vérifiant périodiquement des fils au niveau de chacun des ports pour déceler un défaut, dans lequel la surveillance de ladite condition thermique comprend le suivi d'un changement de courant et le calcul d'un changement de température pour un fil pour identifier une accumulation thermique, et
dans lequel la vérification périodique de fils au niveau de chacun des ports pour déceler le défaut comprend l'évaluation de la stabilité des fils au moins une fois dans un intervalle de temps de 10 millisecondes,
comprenant en outre la coupure de l'alimentation sur un des fils pendant au moins 0,25 milliseconde et l'évaluation du fil et la répétition pour chacun des fils ; et
la vérification d'un déséquilibre électrique au niveau des fils ;
dans lequel le processeur de routage (14) est utilisable pour transmettre de l'énergie dans le système de distribution PoE à une puissance inférieure à 100 watts au démarrage, négocier un niveau de puissance avec la pluralité de dispositifs alimentés, et transmettre une puissance supérieure à 100 watts aux dispositifs alimentés ; et
dans le cas où un défaut est détecté en réponse à l'accumulation thermique et/ou au déséquilibre électrique dépassant une limite spécifiée, le module de détection de défaut (108) est utilisable pour réduire la puissance par la renégociation du niveau de puissance ou la coupure de la sortie de puissance au niveau du processeur de routage (14).

9. Programme informatique, produit-programme informatique ou support lisible par ordinateur comprenant des instructions qui, lorsqu'elles sont exécutées par un ordinateur, amènent l'ordinateur à mettre en œuvre les étapes du procédé selon l'une quelconque des revendications 1 à 7.
